Europäisches Patentamt

European Patent Office

Office européen des brevets

(11) Publication number: **0 331 261 B1**

# EUROPEAN PATENT SPECIFICATION

(45) Date of publication of patent specification: **28.04.93**    (51) Int. Cl.⁵: **G01R 1/18**, G01C 17/38

(21) Application number: **89200482.1**

(22) Date of filing: **27.02.89**

(54) **Apparatus and method for determining azimuth, pitch and roll.**

(30) Priority: **29.02.88 US 162007**

(43) Date of publication of application:
**06.09.89 Bulletin  89/36**

(45) Publication of the grant of the patent:
**28.04.93 Bulletin  93/17**

(84) Designated Contracting States:
**DE FR GB IT**

(56) References cited:
**DE-B- 1 252 796**

(73) Proprietor: **DIGICOURSE, INC.**
**5200 Toler Street**
**Harahan Louisiana 70123(US)**

(72) Inventor: **Fowler, John T.**
**12 Old Salem Road**
**Marblehead Massachusetts 01945(US)**

(74) Representative: **Smulders, Theodorus A.H.J.,**
**Ir. et al**
**Vereenigde Octrooibureaux Nieuwe Parklaan**
**97**
**NL-2587 BN 's-Gravenhage (NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a method of determining the azimuth and pitch relative to a reference frame having first, second and third mutually orthogonal axes, of a structure containing a compass gimballed thereto.

In compasses which incorporate magnetometers having two orthogonally disposed flux gate elements which provide signals from which a heading is calculated, the pitch and roll of the vessel or platform to which the compass is attached is also of interest for itself and because it may affect the heading calculations. Therefore, pitch and roll signals are desired as well as the heading signal. However, separately derived signals are not as good as actually measuring the pitch and roll of the gimballed platform.

Therefore, according to the invention, the heading is calculated by the steps of measuring the ambient magnetic field as three substantially independent components and providing field component signals $Xe$, $Ye$, and $Ze$, respectively along mutually orthogonal X, Y, and Z axes in a reference frame defined by the compass (block 106); applying a first predetermined magnetic field orthogonal to the Y axis of the reference frame (block 112); measuring the independent components of the magnetic field resulting from the superposition of the ambient magnetic field and the first predetermined magnetic field and providing field component signals $Xp$, $Yp$, and $Zp$ (block 114); determining the aximuth ($\theta$) according to the arctangent of ($Ye/Xe$) (block 130); determining the pitch (P) according to the arctangent of $[(Xp-Xe)/(Zp-Ze)]$ - (block 118,120); and transmitting signals representing $\theta$ and P (block 134).

The present invention will be better understood by reading the following detailed description, taken together with the drawing wherein:

Fig. 1 is a block diagram of one embodiment of the present invention;

Fig. 1A is a cross section view of the pitch and roll coils surrounding the sensor; and

Fig. 2 is a flow chart of the process calculating the azimuth, pitch and roll according to one embodiment of the present invention.

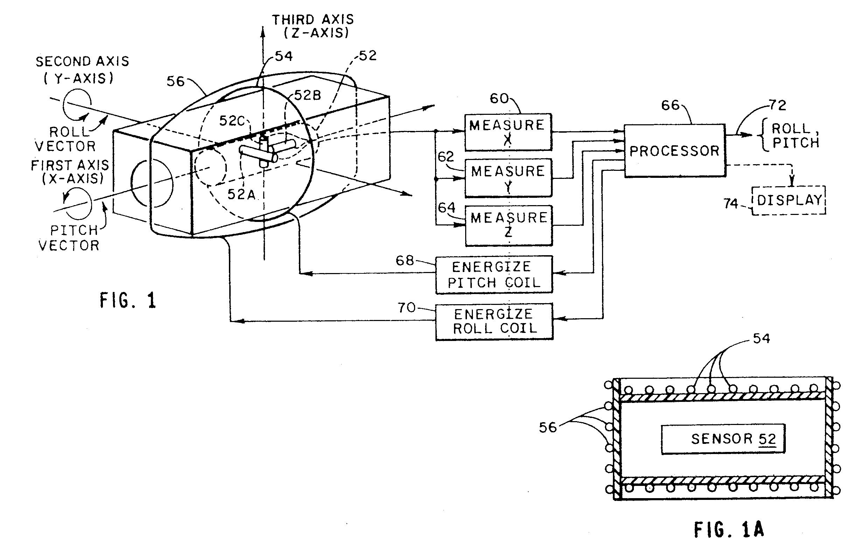

A block drawing of one embodiment of the system 50 is shown in Fig. 1 wherein a sensor 52, containing three orthogonal magnetic field sensing elements 52A, 52B and 52C, typically flux gates, are retained within a structure having a pitch coil 54 and a roll coil 56 disposed thereabout to selectively provide a predetermined DC magnetic field for the process described below. The particular proportions of the pitch and roll coils 52 and 54 is shown more clearly in Fig. 1A, wherein the coils 52 and 54 comprise solenoidally wound coils which extend beyond the sensor 52 such that the lines of flux produced by the respective coils are substantially parallel and uniform in through the sensor 52. The three orthogonal magnetic field sensing elements 52A, 52B and 52C of the sensor 52 define a reference frame for the determination of roll about the Y axis and pitch about the X-axis.

The signals derived by the individual flux gates in the sensor 52 are measured by elements 60, 62 and 64, and received by and stored in a processor 66. The processor sequentially and selectively energizes the pitch and roll coils 54 and 56 according to control signals applied to energization circuits 68 and 70, respectively. The resulting calculated pitch, roll and azimuth is provided on output leads 72 and/or selectively displayed on a display 74.

The embodiment, according to the present invention, includes a processor 66 which comprises typically a microprocessor such as the MCS 48 Series Microprocessor made by Intel Corp., the Motorola 6800 Series Microprocessor made by Motorola Inc or equivalent thereof and is programmed according to the following process according to the present invention by one of skill in the art.

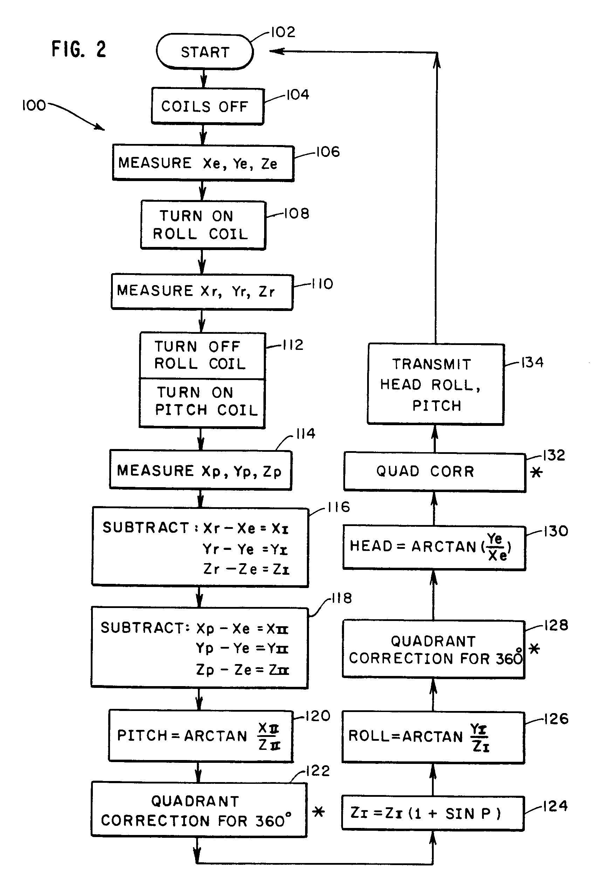

The process of the present invention provides a periodic update of the pitch, roll and azimuth signals. One embodiment of the process is shown in the flow chart 100 in Fig. 2 wherein the process begins at step 102, and turns the coils off at step 104 so that the X, Y and Z signals provided by the sensor 52 and measured by elements 60, 62 and 64, noted as $Xe$, $Ye$ and $Ze$, correspond only to the ambient magnetic field (of the earth) $Hx_1$, $Hy_1$ and $Hz_1$. The measurement is provided at step 106. Subsequently, the roll coil 56 is energized at step 108 and the three signal orthogonal signals are measured at step 110 for the field components $Hx_2$, $Hy_2$ and $Hz_2$ wherein the signals are noted as $Xr$, $Yr$ and $Zr$. Subsequently, the roll coil 56 is deenergized and the pitch coil 54, is energized at step 112. The signals from the sensors are measured at step 114, providing the $Xp$, $Yp$ and $Zp$ signals, corresponding to $Hx_3$, $Hy_3$ and $Hz_3$ comprising the ambient earth magnetic field and the field imposed by the pitch coil. Preferably, the above steps of measuring the sensor signals with and without energization of the particular roll and pitch coils is accomplished in a short interval, such as 15 milliseconds, in order to provide a "snapshot" of the ambient field conditions. If an extended period of time between the readings exists so that the platform to which the compass is attached changes its relative position, changes in ambient field conditions will cause erroneous calculations of the desired signals.

The signals derived when all coils are off ($Xe$, $Ye$ and $Ze$) is subtracted from the signals ($Xr$, $Yr$

and Zr) derived when the roll coil is energized, resulting in difference signals XI, YI and ZI at step 116. Similarly, the signals measured when the coils are not energized are subtracted at step 118 from the signals (Zp, Yp and Zp) derived when the pitch coil is energized providing signals XII, YII and ZII.

In step 120, the pitch (P) is calculated according to the arctangent of XII/ZII (arctangent ($Hx_2$ - $Hx_1$)/($Hz_2$ - $Hz_1$)). In step 122, a quadrant correction is applied such that if the value of XII (Hx signal) is less than 0, 180° is added to the value of pitch, and if the value XII (Hx) is greater than 0 and the value of ZII (Hy) is less than 0, a value of 360° is added to the calculated value of pitch. Subsequently, at step 124, the value of ZI is multiplied by 1 + sin p where P is the calculated pitch angle.

The roll (R) is calculated at step 126 according to the arctangent of YI/ZI (arctangent ($Hy_2$ - $Hy_1$)/($Hz_2$ - $Hz_1$)), and is corrected at the optional step 128, which incorporates the quadrant correction according to step 122 as applied to the calculated roll angle.

The azimuth ($\theta$) is calculated at step 130 according to the arctangent of the initially measured values of Ye/Xe (arctangent $Hy_1$/$Hx_1$). Quadrant correction is applied at the optional step 132, incorporating the procedure of step 122, discussed above, as applied to the calculated azimuth angle.

Finally, the calculated heading, pitch and roll values are transmitted to the external apparatus or to the display 74 at step 134, whereupon the method of determining azimuth, pitch and roll according to the present invention is begun again at step 102.

## Claims

1. A method of determining the azimuth and pitch relative to a reference frame having first, second and third mutually orthogonal axes, of a structure containing a compass gimballed thereto, characterized by the steps of measuring the ambient magnetic field as three substantially independent components and providing field component signals Xe, Ye, and Ze, respectively along mutually orthogonal X, Y, and Z axes in a reference frame defined by the compass (block 106); applying a first predetermined magnetic field orthogonal to the Y axis of the reference frame (block 112); measuring the independent components of the magnetic field resulting from the superposition of the ambient magnetic field and the first predetermined magnetic field and providing field component signals Xp, Yp, and Zp (block 114); determining the azimuth ($\theta$) according to the arctangent of (Ye/Xe) (block 130); determining the pitch (P) according to the arctangent of [(Xp-Xe)/(Zp-Ze)] (block 118,120); and transmitting signals representing azimuth and pitch (block 134).

2. The method of claim 1, characterized by the steps of removing said first predetermined magnetic field and applying a second predetermined magnetic field orthogonal to the direction of the first predetermined magnetic field (block 112); measuring the independent components of the magnetic field resulting from the superposition of the ambient field and the second predetermined magnetic field and providing field component signals Xr, Yr, and Zr (block 110); determining the roll (R) according to the arctangent of {(Yr-Ye)/[(Zr-Ze) (1 + sin P)]} (block 116,124,126); and transmitting signals representing roll (block 134).

3. A method of determining the azimuth and roll, relative to a reference frame having first, second and third mutually orthogonal axes of a structure containing a compass gimballed thereto, characterized by the steps of measuring the ambient magnetic field as three substantially independent components and providing field component signals Xe, Ye, and Ze, respectively along the mutually orthogonal X, Y, and Z axes in said reference frame defined by the compass (block 106); applying a predetermined magnetic field orthogonal to the X axis of the reference frame (block 108); measuring the independent components of the magnetic field resulting from the superposition of the ambient field and the predetermined magnetic field and providing field component signals Xr, Yr, and Zr (block 110); determining the azimuth ($\theta$) according to the arctangent of (Ye/Xe) (block 130); determining the roll (R) according to the arctangent of [(Yr-Ye)/(Zr-Ze)] (block 116,126); and transmitting signals representing azimuth and roll (block 134).

4. Apparatus for determining azimuth and pitch of a structure, according to the method of claim 1, characterized by a magnetometer (52,60,62,64) contained in the structure and having three mutually orthogonal sensing elements defining said reference frame comprising said X, Y, and Z axes, said magnetometer being moveable with respect to the structure about the X axis in roll and the Y axis in pitch and providing output signals Xe, Ye, and Ze, representing orthogonal components of the ambient magnetic field in the reference frame; means (54) for applying a first substantially uniform magnetic field about said magnetometer orthogonal to the Y axis of the reference frame according to a first control signal (68), said magnetometer providing signals Xp, Yp, and Zp representing orthogonal components of the superposition of the ambient field and the first uniform magnetic field in the reference frame; means (66) for determining the pitch of the structure with respect to the magnetometer according to the arctangent of [(Xp-Xe)/(Zp-Ze)]; means (66) for determining the azimuth of the structure according to the arctangent of (Ye/Xe); and output means for providing output signals corresponding to the determined pitch and azimuth (72).

5. The apparatus according to claim 4, <u>character-ized by</u> means (56) for providing a second substantially uniform magnetic field about said magnetometer (52,60,62,64) orthogonal to the first substantially uniform magnetic field according to a second control signal (70), said magnetometer providing magnetometer output signals Xr, Yr, and Zr representing orthogonal components of the superposition of the ambient field and the second uniform magnetic field in the reference frame; and means (66) for determining the roll of the structure according to the arctangent of {(Yr-Ye)/[(Zr-Ze)(1 + sin P)]}, wherein said output means further provides an output signal corresponding to the determined roll (72).

6. Apparatus for determining the azimuth and roll of a structure in an ambient magnetic field, according to the method of claim 3, <u>character-ized by</u> a magnetometer (52,60,62,64) contained in the structure and having three mutually orthogonal sensing elements, defining a reference frame comprising said X, Y, and Z axes, said magnetometer being moveable with respect to the structure about the X axis in roll and the Y axis in pitch and providing output signals Xe, Ye, and Ze representing orthogonal components of the ambient magnetic field in the reference frame; means (56) for providing a substantially uniform magnetic field about said magnetometer substantially orthogonal to the X axis of the reference frame according to a control signal (70), said magnetometer providing output signals Xr, Yr, and Zr representing orthogonal components of the superposition of the ambient field and the substantially uniform magnetic field in the reference frame; means (66) for determining the roll of the structure according to the arctangent of [(Yr-Ye)/(Zr-Ze)]; means (66) for determining the azimuth of the structure according to the arctangent of (Ye/Xe); and output means for providing output signals corresponding to the determined roll and azimuth (72).

**Patentansprüche**

1. Verfahren zur Bestimmung von Azimut und Neigung relativ zu einem Meßrahmen mit ersten, zweiten und dritten zueinander orthogonalen Achsen einer Struktur, die einen darauf kardanisch aufgehängten Kompaß enthält, gekennzeichnet durch folgende Schritte: Messen des Umgebungsmagnetfeldes in Form dreier im wesentlichen unabhängiger Komponenten und Liefern bzw. Erzeugen von Feldkomponentensignalen Xe, Ye und Ze, jeweils entlang zueinander orthogonaler X-, Y- und Z-Achsen in einem durch den Kompaß definierten Meßrahmen (Block 106); Anlegen eines ersten - zur Y-Achse des Meßrahmens orthogonalen - vorgegebenen Magnetfeldes (Block 112); Messen der unabhängigen Komponenten des Magnetfeldes, die aus der Überlagerung des Umge-bungsmagnetfeldes und des ersten vorgegebe-nen Magnetfeldes resultieren und Erzeugen von Feldkomponentensignalen Xp, Yp und Zp (Block 114); Bestimmen des Azimuts ($\theta$) ent-sprechend dem Arkustangens von (Ye/Xe) - (Block 130); Bestimmen der Neigung (P) ent-sprechend dem Arkustangens von [(Xp-Xe)/-(Zp-Ze)] (Block 118,120); und Übertragen von Signalen, die Azimut und Neigung darstellen (Block 134).

2. Verfahren nach Anspruch 1, gekennzeichnet durch folgende Schritte: Entfernen des ersten vorgegebenen Magnetfeldes und Anlegen eines zweiten - zur Richtung des ersten vorge-gebenen Magnetfeldes orthogonalen - vorge-gebenen Magnetfeldes (Block 112); Messen der unabhängigen Komponenten des Magnetfeldes, die aus der Überlagerung des Umge-bungsfeldes und des zweiten vorgegebenen Ma-gnetfeldes resultieren und Erzeugen von Feldkomponentensignalen Xr, Yr und Zr (Block 110); Bestimmen des Rollens (R) entspre-chend dem Arkustangens von {(Yr-Ye)/[Zr-Ze) (1 + sin P)]} (Block 116, 124, 126); und Übertragen der das Rollen darstellenden Signale (Block 134).

3. Verfahren zur Bestimmung von Azimut und Rollen relativ zu einem Meßrahmen mit ersten, zweiten und dritten zueinander orthogonalen Achsen einer Struktur, die einen darauf karda-nisch aufgehängten Kompaß enthält, gekenn-zeichnet durch folgende Schritte: Messen des Umgebungsmagnetfeldes in Form dreier im wesentlichen unabhängiger Komponenten und Erzeugen von Feldkomponentensignalen Xe, Ye und Ze, jeweils entlang zueinander orthogonaler X-, Y- und Z-Achsen in dem durch den Kompaß definierten Meßrahmen (Block 106); Anlegen eines zur X-Achse des Meßrahmens orthogonalen vorgegebenen Magnetfeldes (Block 108); Messen der unabhängigen Komponenten des Magnetfeldes, die aus der Überlagerung des Umgebungsfeldes und des vorgegebenen Magnetfeldes resultieren und Erzeugen von Feldkomponentensignalen Xr, Yr und Zr (Block 110); Bestimmen des Azimuts ($\theta$) entsprechend dem Arkustangens von (Ye/Xe) (Block 130); Bestimmen des Rollens (R) entsprechend dem Arkustangens von [(Yr-Ye)/(Zr-Ze)] (Block 116, 126); und Übertragen der Signale, die Azimut und Rollen darstellen (Block 134).

4. Vorrichtung zur Bestimmung von Azimut und Neigung einer Struktur entsprechend dem Verfahren von Anspruch 1, gekennzeichnet durch ein in der Struktur enthaltenes Magnetometer (52, 60, 62, 64) mit drei zueinander orthogonalen Fühlern, die den Meßrahmen definieren, der die X-, Y- und Z-Achsen umfaßt, wobei das Magnetometer in Bezug auf die Struktur über die X-Achse in Rollrichtung und die Y-Achse in Neigungsrichtung beweglich ist und die Ausgangssignale Xe, Ye und Ze liefert, die die orthogonalen Komponenten des Umgebungsmagnetfeldes im Meßrahmen darstellen; Mittel (54) zum Anlegen eines ersten - zur Y-Achse des Meßrahmens orthogonalen - im wesentlichen gleichförmigen Magnetfeldes am Magnetometer aufgrund eines ersten Steuersignals (68), wobei das Magnetometer Signale Xp, Yp und Zp liefert, die die orthogonalen Komponenten der Überlagerung des Umgebungsfeldes und des ersten homogenen Magnetfeldes im Meßrahmen darstellen; Mittel (66) zur Bestimmung der Neigung der Struktur in Bezug auf das Magnetometer entsprechend dem Arkustangens [(Xp-Xe)/(Zp-Ze)]; Mittel (66) zur Bestimmung des Azimuts der Struktur entsprechend dem Arkustangens von (Ye/Xe); und Ausgangs- bzw Ausgabemittel zur Lieferung von Ausgangssignalen, die den bestimmten Neigung und Azimut (72) entsprechen.

5. Vorrichtung nach Anspruch 4, gekennzeichnet durch Mittel (56) zur Erzeugung eines zeiten - zum ersten im wesentlichen homogenen Magnetfeldes orthogonalen - im wesentlichen homogenen Magnetfeldes am Magnetometer (52, 60, 62, 64) aufgrund eines zweiten Steuersignals (70), wobei das Magnetometer Magnetometer-Ausgangssignale Xr, Yr und Zr liefert, die orthogonale Komponenten der Überlagerung des Umgebungsfeldes und des zweiten homogenen Magnetfeldes im Meßrahmen darstellen; und durch Mittel (66) zur Bestimmung des Rollens der Struktur gemäß dem Arkustangens von {(Yr-Ye)/ [(Zr-Ze) (1 + sin P)]}, wobei die Ausgangs- bzw. Ausgabemittel außerdem ein Ausgangssignal liefern, das dem bestimmten Rollen entspricht (72).

6. Vorrichtung zur Bestimmung von Azimut und Rollen einer Struktur in einem Umgebungsmagnetfeld entsprechend dem Verfahren von Anspruch 3, gekennzeichnet durch ein in der Struktur enthaltenes Magnetometer (52, 60, 62, 64) mit drei zueinander orthogonalen Fühlern, die einen Meßrahmen definieren, der die X-, Y- und Z-Achsen umfaßt, wobei das Magnetometer in Bezug auf die Struktur über die X-Achse in Rollrichtung und die Y-Achse in Neigungsrichtung beweglich ist und die Ausgangssignale Xe, Ye und Ze liefert, die die orthogonalen Komponenten des Umgebungsmagnetfeldes im Meßrahmen darstellen; Mittel (56) zur Erzeugung eines - im wesentlichen zur X-Achse des Meßrahmens orthogonalen - im wesentlichen gleichförmigen Magnetfeldes am Magnetometer aufgrund eines Steuersignals (70), wobei das Magnetometer die Ausgangssignale Xr, Yr und Zr liefert, die die orthogonalen Komponenten der Überlagerung des Umgebungsfeldes und des im wesentlichen gleichförmigen Magnetfeldes im Meßrahmen darstellen; Mittel (66) zur Bestimmung des Rollens der Struktur gemäß dem Arkustangens von [(Yr-Ye)/(Zr-Ze)]; Mittel (66) zur Bestimmung von Azimut der Struktur gemäß dem Arkustangens von (Ye/Xe); und Ausgangsmittel zur Lieferung von Ausgangssignalen, die den bestimmten Rollen und Azimut entsprechen (72).

**Revendications**

1. Procédé de détermination de l'azimut et du tangage, par rapport à un cadre de référence ayant des premier, deuxième et troisième axes perpendiculaires les uns aux autres, d'une structure dans laquelle un compas est suspendu à la cardan, caractérisé par les étapes de mesure du champ magnétique ambiant sous forme de trois composantes sensiblement indépendantes et d'émission de signaux de composante de champ Xe, Ye et Ze, respectivement, le long d'axes X, Y et Z perpendiculaires les uns aux autres dans un cadre de référence déterminé par le compas (bloc 106) ; de production d'un premier champ magnétique prédéterminé qui est perpendiculaire à l'axe Y du cadre de référence (bloc 112) ; de mesure des composantes indépendantes du champ magnétique résultant de la superposition du champ magnétique ambiant et du premier champ magnétique prédéterminé et d'émission de signaux de composante de champ Xp, Yp et Zp (bloc 114) ; de détermination de l'azimut ($\theta$) d'après l'arc tangente de (Ye/Xe) (bloc 130) ; de détermination du tangage (P) d'après l'arc tangente de [(Xp-Xe)/(Zp-Ze)] (blocs 118, 120) ; et de transmission des signaux représentant l'azimut et le tangage (bloc 134).

2. Procédé selon la revendication 1, caractérisé par les étapes d'élimination dudit premier champ magnétique prédéterminé et de production d'un second champ magnétique prédéterminé qui est perpendiculaire à la direction du premier champ magnétique prédéterminé (bloc 112) ; de mesure des composantes indépendantes du champ magnétique résultant de la superposition du champ ambiant et du second champ magnétique prédéterminé et d'émission de signaux de composante de champ Xr, Yr et Zr (bloc 110) ; de détermination du roulis (R) d'après l'arc tangente de {-(Yr-Ye)/[(Zr-Ze)(1 + sin P)]} (blocs 116, 124, 126) ; et de transmission des signaux représentant le roulis (bloc 134).

3. Procédé de détermination de l'azimut et du roulis, par rapport à un cadre de référence ayant des premier, deuxième et troisième axes perpendiculaires les uns aux autres, d'une structure dans laquelle un compas est suspendu à la cardan, caractérisé par les étapes de mesure du champ magnétique ambiant sous forme de trois composantes sensiblement indépendantes et d'émission de signaux de composante de champ Xe, Ye et Ze, respectivement, le long d'axes X, Y et Z perpendiculaires les uns aux autres dans ledit cadre de référence déterminé par le compas (bloc 106) ; de production d'un champ magnétique prédéterminé perpendiculaire à l'axe X du cadre de référence (bloc 108) ; de mesure des composantes indépendantes du champ magnétique résultant de la superposition du champ ambiant et du champ magnétique prédéterminé et d'émission de signaux de composante de champ Xr, Yr et Zr (bloc 110) ; de détermination de l'azimut ($\theta$) d'après l'arc tangente de (Ye/Xe) (bloc 130) ; de détermination du roulis (R) suivant l'arc tangente de [(Yr-Ye)/(Zr-Ze)] - (blocs 116, 126) ; et de transmission de signaux représentant l'azimut et le roulis (bloc 134).

4. Appareil de détermination de l'azimut et du tangage d'une structure selon le procédé de la revendication 1, caractérisé par un magnétomètre (52, 60, 62, 64) que comprend la structure et qui comporte trois éléments détecteurs perpendiculaires les uns aux autres et déterminant ledit cadre de référence comprenant lesdits axes X, Y et Z, ledit magnétomètre étant mobile par rapport à la structure en roulis autour de l'axe X et en tangage autour de l'axe Y et émettant des signaux de sortie Xe, Ye et Ze représentant des composantes perpendiculaires du champ magnétique ambiant dans le cadre de référence ; des moyens (54) de production d'un premier champ mangétique sensiblement uniforme autour dudit magnétomètre perpendiculairement à l'axe Y du cadre de référence en fonction d'un premier signal de commande (68), ledit magnétomètre émettant des signaux Xp, Yp et Zp représentant des composantes orthogonales de la superposition du champ magnétique ambiant et du premier champ magnétique uniforme dans le cadre de référence ; des moyens (66) de détermination du tangage de la structure par rapport au magnétomètre d'après l'arc tangente de [(Xp-Xe)/(Zp-Ze)] ; des moyens (66) de détermination de l'azimut de la structure d'après l'arc tangente de (Ye/Xe) ; et des moyens de sortie destinés à émettre des signaux de sortie correspondant au tangage et à l'azimut (72) déterminés.

5. Appareil selon la revendication 4, caractérisé par des moyens (56) de production d'un second champ magnétique sensiblement uniforme autour dudit magnétomètre (52, 60, 62, 64) perpendiculairement au premier champ magnétique sensiblement uniforme en fonction d'un second signal de commande (70), ledit magnétomètre émettant des signaux de sortie de magnétomètre Xr, Yr et Zr représentant des composantes orthogonales de la superposition du champ ambiant et du second champ magnétique uniforme dans le cadre de référence ; et des moyens (66) de détermination du roulis de la structure d'après l'arc tangente de {(Yr-Ye)/[(Zr-Ze)(1 + sin P)]}, lesdits moyens de sortie émettant de plus un signal de sortie correspondant au roulis déterminé (72).

6. Appareil de détermination de l'azimut et du roulis d'une structure dans un champ magnétique ambiant selon le procédé de la revendication 3, caractérisé par un magnétomètre (52, 60, 62, 64) que comprend la structure et qui comporte trois éléments détecteurs perpendiculaires les uns aux autres et déterminant un cadre de référence comprenant lesdits axes X, Y et Z, ledit magnétomètre étant mobile par rapport à la structure en roulis autour de l'axe X et en tangage autour de l'axe Y et émettant des signaux de sortie Xe, Ye et Ze représentant des composantes orthogonales du champ magnétique ambiant dans le cadre de référence ; des moyens (56) de production d'un champ magnétique sensiblement uniforme autour dudit magnétomètre à peu près perpendiculairement à l'axe X du cadre de référence en fonction d'un signal de commande (70), ledit magnétomètre émettant des signaux de sortie Xr, Yr, et Zr représentant des composantes orthogonales de la superposition du champ ambiant et du champ magnétique sensiblement uniforme dans le cadre de référence ; des moyens (66) de détermination du roulis de la structure d'après l'arc tangente de [(Yr-Ye)/-(Zr-Ze)] ; des moyens (66) de détermination de l'azimut de la structure d'après l'arc tangente de (Ye/Xe) ; et des moyens de sortie destinés à émettre des signaux de sortie correspondant au roulis et à l'azimut (72) déterminés.

FIG. 1

FIG. 1A

EP 0 331 261 B1

FIG. 2

START $\sim$102

100

COILS OFF $\sim$104

MEASURE Xe, Ye, Ze $\sim$106

TURN ON ROLL COIL $\sim$108

MEASURE Xr, Yr, Zr $\sim$110

TURN OFF ROLL COIL / TURN ON PITCH COIL $\sim$112

TRANSMIT HEAD ROLL, PITCH $\sim$134

MEASURE Xp, Yp, Zp $\sim$114

QUAD CORR * $\sim$132

SUBTRACT: $Xr - Xe = X_I$ / $Yr - Ye = Y_I$ / $Zr - Ze = Z_I$ $\sim$116

$HEAD = ARCTAN \left(\dfrac{Ye}{Xe}\right)$ $\sim$130

SUBTRACT: $Xp - Xe = X_{II}$ / $Yp - Ye = Y_{II}$ / $Zp - Ze = Z_{II}$ $\sim$118

QUADRANT CORRECTION FOR 360° * $\sim$128

$PITCH = ARCTAN \dfrac{X_{II}}{Z_{II}}$ $\sim$120

$ROLL = ARCTAN \dfrac{Y_I}{Z_I}$ $\sim$126

QUADRANT CORRECTION FOR 360° * $\sim$122

$Z_I = Z_I (1 + SIN P)$ $\sim$124